(19) Europäisches Patentamt
European Patent Office
Office européen des brevets

(11) **EP 3 661 042 A1**

(12) **EUROPEAN PATENT APPLICATION**
published in accordance with Art. 153(4) EPC

(43) Date of publication:
**03.06.2020 Bulletin 2020/23**

(51) Int Cl.:
***H02M 7/48*** *(2007.01)*

(21) Application number: **18837405.2**

(22) Date of filing: **28.03.2018**

(86) International application number:
**PCT/JP2018/012829**

(87) International publication number:
**WO 2019/021532 (31.01.2019 Gazette 2019/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.07.2017 JP 2017147141**

(71) Applicant: **Hitachi, Ltd.
Tokyo 100-8280 (JP)**

(72) Inventors:
• **URUSHIWARA, Noriyoshi
Tokyo 100-8280 (JP)**
• **NAKATA, Kiyoshi
Tokyo 100-8280 (JP)**
• **TERAKADO, Shuichi
Tokyo 100-8280 (JP)**

(74) Representative: **Mewburn Ellis LLP
Aurora Building
Counterslip
Bristol BS1 6BX (GB)**

(54) **ELECTRIC-POWER CONVERSION DEVICE**

(57) In the present invention, P-pole and N-pole thin-plate-shaped busbars, formed to stand in a direction perpendicular to an attachment surface of a 2in1 power semiconductor module, are adjacently attached to said power semiconductor module so as to face each other. Said thin-plate-shaped busbars are connected to terminals that are provided on a side of a filter capacitor at an offset to the power semiconductor module.

FIG.6

EP 3 661 042 A1

**Description**

Technical Field

The present invention relates to a mounting structure of equipment in an electric-power conversion device, and is particularly suitable by being applied to an electric-power conversion device in which a power semiconductor module is mounted.

Background Art

An electric-power conversion device installed in a railroad vehicle is a device that controls an electric motor that drives a vehicle such as an electric railroad vehicle. The electric-power conversion device is mainly installed under the floor of a vehicle, and converts electric power input from a railroad wire by switching operations of a main circuit including plural power semiconductor modules. The converted electric power is used to control an electric motor for railroad vehicles. The main circuit that is a primary constitutional device of the electric-power conversion device includes, for example, a power semiconductor module having a power switching element, a gate drive device that is a driving circuit thereof, and a filter capacitor that stabilizes DC electric power input from a wire (see Patent Literature 1).

Citation List

Patent Literature

[Patent Literature 1] Japanese Unexamined Patent Application Publication No. Hei11 (1999)-251499

Summary of Invention

Technical Problem

However, for example, in the case where the electric-power conversion device is installed under the floor of a low floor vehicle such as a streetcar, the height dimension of the electric-power conversion device in the vertical direction has been one of restrictions when being installed in a relation of a distance to the ground surface.
The present invention has been made in consideration of the above-described point, and proposes an electric-power conversion device that can be easily mounted in a low floor vehicle while suppressing the height dimension in the vertical direction when being installed.

Solution to Problem

In order to solve the above-described problem, the present invention provides an electric-power conversion device comprising: a power semiconductor module in which each of an upper arm power switching element and a lower arm power switching element is driven in accordance with conduction modes to a P-pole terminal and an N-pole terminal; a gate drive device that controls conduction to the power semiconductor module through the P-pole terminal and the N-pole terminal; a filter capacitor in which plural terminals each of which is connected to the P-pole terminal and the N-pole terminal are formed on the power semiconductor module side; a cooler that cools the power semiconductor module through a predetermined surface with which the power semiconductor module comes into contact; and plural thin plate-shaped busbars that electrically connect the P-pole terminal and the N-pole terminal to the plural terminals, wherein the filter capacitor is arranged near the power semiconductor module along the predetermined surface and the plural terminals are arranged on the side of the P-pole terminal and the N-pole terminal, and wherein the plural thin plate-shaped busbars are formed substantially in parallel with the vertical direction with respect to the predetermined surface.

Advantageous Effects of Invention

According to the present invention, an electric-power conversion device can be easily mounted in a low floor vehicle while suppressing the height dimension in the vertical direction when being installed.

Brief Description of Drawings

Fig. 1 is a partial cross-sectional view for showing a configuration example of a railroad vehicle in which an electric-power conversion device according to a first embodiment is mounted.
Fig. 2 is an upper-surface perspective view for showing a configuration example of the electric-power conversion device shown in Fig. 2.
Fig. 3 is a bottom-surface perspective view for showing a configuration example of the electric-power conversion device shown in Fig. 2.
Fig. 4 is a side-surface perspective view for showing a configuration example of the electric-power conversion device shown in Fig. 2.
Fig. 5 is a circuit diagram for showing a configuration example of a main circuit and a control logic unit of the electric-power conversion device shown in Fig. 2.
Fig. 6 is a cross-sectional view for showing an example of a basic configuration of the electric-power conversion device.
Fig. 7 is a diagram obtained by enlarging a part denoted by a range W shown in Fig. 6.
Fig. 8 is a perspective view for showing a configuration example when a main circuit part of the electric-power conversion device shown in Fig. 2 is viewed from the element attachment surface side.
Figs. 9 are a plan view and a circuit diagram for showing a configuration example of a power semiconductor module.

Fig. 10 is a perspective view for showing a configuration example of the power semiconductor module shown in Fig. 9(A).

Fig. 11 is a perspective view for showing a configuration example of an electric-power conversion device according to a second embodiment.

Fig. 12 is a perspective view for showing a configuration example of an electric-power conversion device according to a third embodiment.

Fig. 13 is a perspective view for showing a configuration example of an electric-power conversion device according to a fourth embodiment.

Fig. 14 is a perspective view for showing a configuration example of an electric-power conversion device according to a fifth embodiment.

Fig. 15 is a plan view for showing a configuration example of an electric-power conversion device according to a sixth embodiment.

Fig. 16 is a plan view for showing a partial configuration example of an electric-power conversion device according to a seventh embodiment.

Fig. 17 is a plan view for showing a configuration example of an electric-power conversion device according to an eighth embodiment.

Fig. 18 is a plan view for showing a configuration example of an electric-power conversion device according to a ninth embodiment.

Fig. 19 is a plan view for showing a configuration example of an electric-power conversion device according to a tenth embodiment.

Description of Embodiments

Hereinafter, an embodiment of the present invention will be described in detail with reference to the drawings.

(1) First Embodiment

(1-1) Configuration example

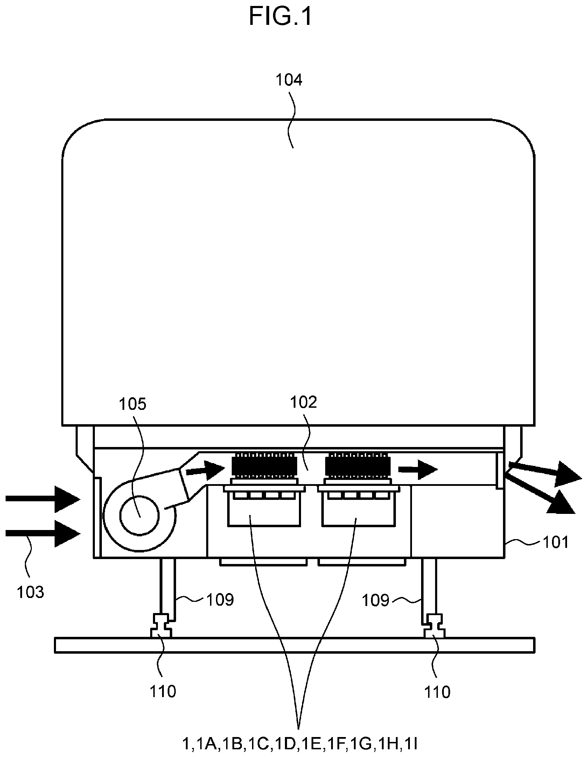

Fig. 1 shows an outlined configuration example of a railroad vehicle including an electric-power conversion device 1 according to a first embodiment. The railroad vehicle is a low floor vehicle that runs with wheels 109 on railroad tracks 110 by using power (not shown), and includes an air blower 105, a ventilation chamber 102, and the electric-power conversion device 1 under the floor of a vehicle body 104.

The electric-power conversion device 1 is housed in a housing 101 attached to the floor of the vehicle body 104, and is cooled by exposing a heat radiation member to cooling air 103 flowing in the ventilation chamber 102 in the case of, for example, an air-cooling type. Hereinafter, a configuration of the electric-power conversion device 1 will be described in detail.

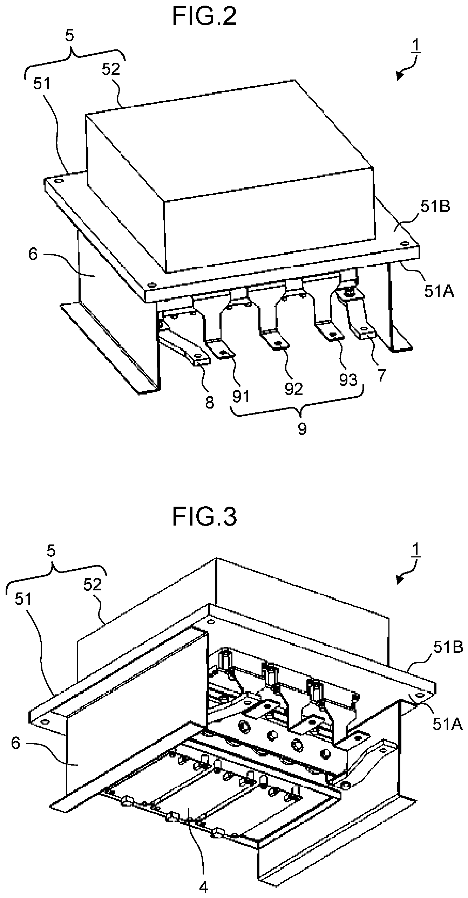

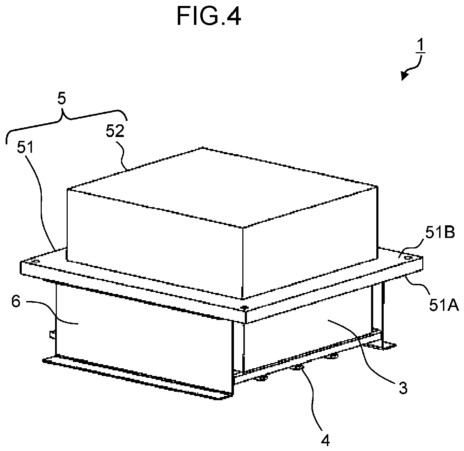

Each of Fig. 2 to Fig. 4 shows a configuration example of the electric-power conversion device 1 shown in Fig. 1. It should be noted that Fig. 2 shows an example of an appearance in the case of viewing an upper surface of the electric-power conversion device 1 from the upper side, Fig. 3 shows an example of an appearance in the case of viewing a bottom surface of the electric-power conversion device 1 from the lower side, and Fig. 4 shows an example of an appearance in the case of viewing a side surface of the electric-power conversion device 1 from a point positioned slightly upward.

The electric-power conversion device 1 is a device that generates a DC from a single-phase AC, or generates a three-phase AC from a DC. In general, the former is referred to as a converter whereas the latter is referred to as an inverter.

First, the converter converts a single-phase AC voltage from an AC power supply into a DC voltage, has a function of charging a filter capacitor 3 for smoothing a DC voltage, and is configured using a two-phase leg.

On the other hand, the inverter has a function of converting a DC voltage charged to the filter capacitor 3 into an AC voltage by continuously changing a ratio of ON/OFF of each power switching element included in a power semiconductor module, and configures a three-phase leg. Accordingly, the inverter generates a three-phase AC, energizes each power switching element of the power semiconductor module using the three-phase AC through a U-phase busbar 91, a V-phase busbar 92, and a W-phase busbar 93, and drives an electric motor (not shown) mounted in a wagon installed under the floor of the vehicle body 104. Both of the converter and the inverter convert electric power by controlling the conduction of each power switching element.

As such a power switching element, there is an Si-IGBT characterized in that ON resistance and a driving current are small and a switching speed is fast. Alternatively, an SiC-MOSFET that can perform a faster switching operation may be employed.

The electric-power conversion device 1 basically includes a support frame (frame) 6, a power semiconductor module, a cooler 5, busbars 7, 8, and 9, the filter capacitor 3, and a gate drive device 4.

The power semiconductor module 2 includes, for example, U-phase, V-phase, and W-phase power switching elements having the P-pole and N-pole. Each power switching element generates heat when being in a conductive state and being cutoff. The power semiconductor module 2 will be described later in detail.

The cooler 5 has a function of cooling the power semiconductor module that largely consumes electric power to generate heat when being in a conductive state and being cutoff. An air-cooling type or a water-cooling type can be employed for the cooler 5. As the air-cooling type, a radiator type, a heat pipe type, or a fin type can be employed.

The cooler 5 includes, for example, a rectangular flat plate-like cooling block 51, and includes a box-like heat radiation member 52 arranged nearly in the center of one surface (corresponding to a surface facing upward in the drawing) of the cooling block 51.

The cooler 5 is supported by support frames 6 around rectangular both side parts facing each other in the other surface 51A (corresponding to a surface facing downward in the drawing) of the cooling block 51. It should be noted that the power semiconductor module 2 is arranged along the other surface 51A. Hereinafter, the other surface 51A is also referred to as an "element attachment surface". In the power semiconductor module 2, the support frames 6 are basic structures configuring the electric-power conversion device 1, and are used, as the function thereof, when being fixed to the housing 101 or when holding the cooler 5 or other constitutional devices.

These support frames 6 are rectangular flat plate-like members fixed so as to rise nearly in the vertical direction from the other surface 51A of the cooling block 51, and other side members of the flat plate parts that do not come into contact with the other surface 51A of the cooling block 51 are configured to be bent outward in the direction parallel to the other surface 51A. Surfaces on one side of the other side members configured to be bent are fixed to, for example, a bottom part of the low floor vehicle when the electric-power conversion device 1 is attached to the bottom part.

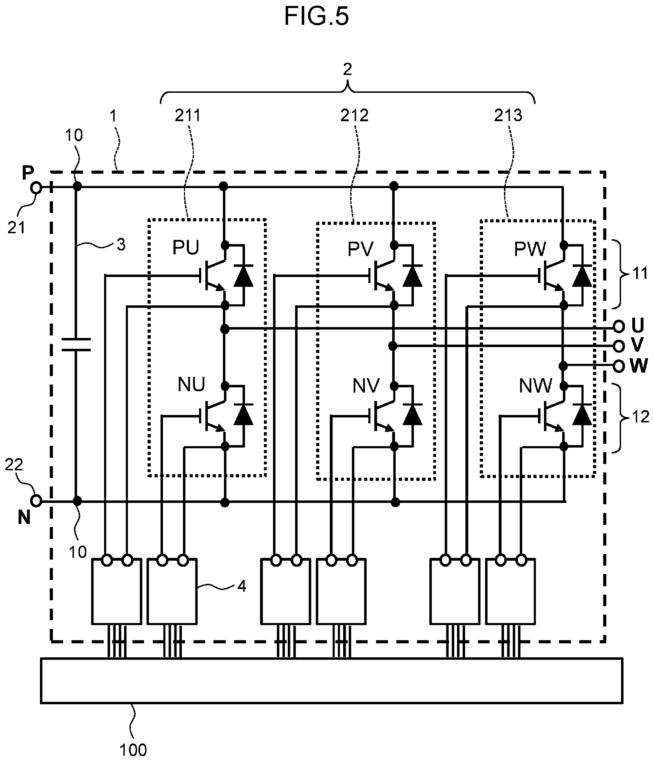

Fig. 5 shows a configuration example of a main circuit and a control logic unit 100 of the electric-power conversion device 1. As feeding systems of a railroad, there are an AC-type system and a DC-type system in general. In addition, as main electric motors, there are an AC electric motor and a DC electric motor. Thus, only an inverter or a converter, or a combination thereof can be used in the electric-power conversion device 1 in accordance with a combination of a feeding system and an electric motor. In the embodiment, an inverter applied to a combination of a DC feeding system and an AC electric motor will be described as an example.

The main circuit in the embodiment is configured to have the filter capacitor 3 and a three-phase inverter connected in electric circuit paths between the P-pole busbar 7 and the N-pole busbar 8 that are DC terminals.

The three-phase inverter converts an input DC into a three-phase AC having an arbitrary frequency and an arbitrary voltage, and outputs the three-phase AC to AC terminals U, V, and W. The three-phase inverter includes six groups of power switching elements (PU, NU, PV, NV, PW, and NW) of a U-phase 211, a V-phase 212, and a W-phase 213.

The power switching element in each phase includes an element and a freewheel diode connected in parallel with the element. In the example of the drawing, Si-IGBT is an example of a circuit symbol as the power switching element, but SiC-MOSFET may be used instead.

The control logic unit 100 is provided separately from the electric-power conversion device 1, and outputs a control signal to the electric-power conversion device 1 through the gate drive device 4 in conduction control. The control logic unit 100 drives each power switching element of the power semiconductor module 2 using the control signal.

The gate drive device 4 is arranged on the surface side opposite to the cooler 5 with the filter capacitor 3 therebetween. Electronic components mounted in the gate drive device 4 may malfunction due to heat or the lifetime of the gate drive device 4 may become short. For example, the power semiconductor module 2 and wirings such as the busbars 7, 8, and 9 generate heat by themselves, and the temperature of the vicinity thereof possibly increases. Thus, the gate drive device 4 is desirably arranged at a position where a thermal influence by the surrounding heating components can be avoided.

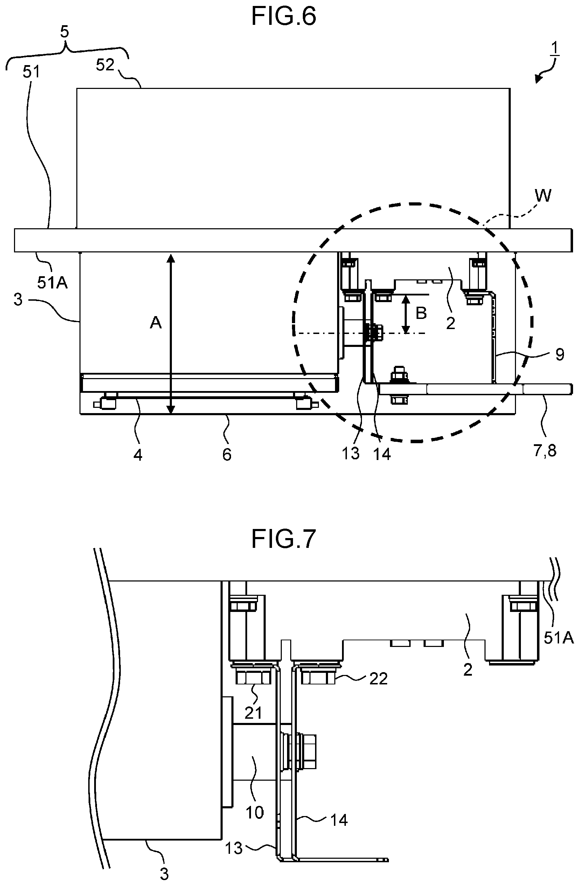

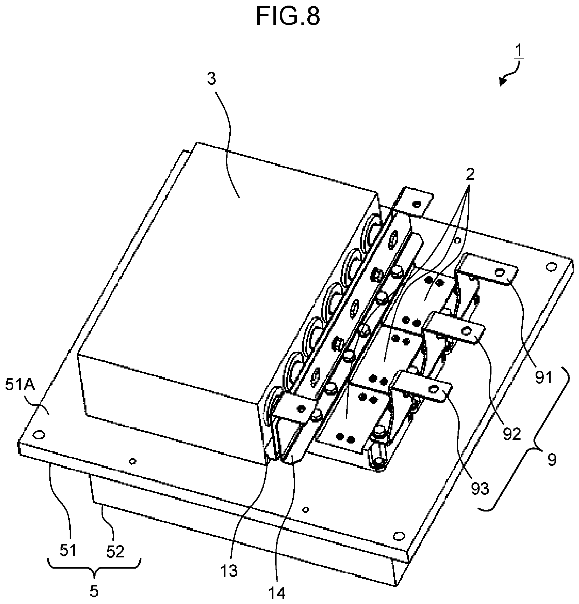

Fig. 6 is a cross-sectional view for showing an example of a basic configuration of the electric-power conversion device 1, and Fig. 7 is a diagram obtained by enlarging a part denoted by a range W shown in Fig. 6. Fig. 8 is a perspective view for showing a configuration example when the main circuit part of the electric-power conversion device 1 shown in Fig. 2 is viewed from the element attachment surface side.

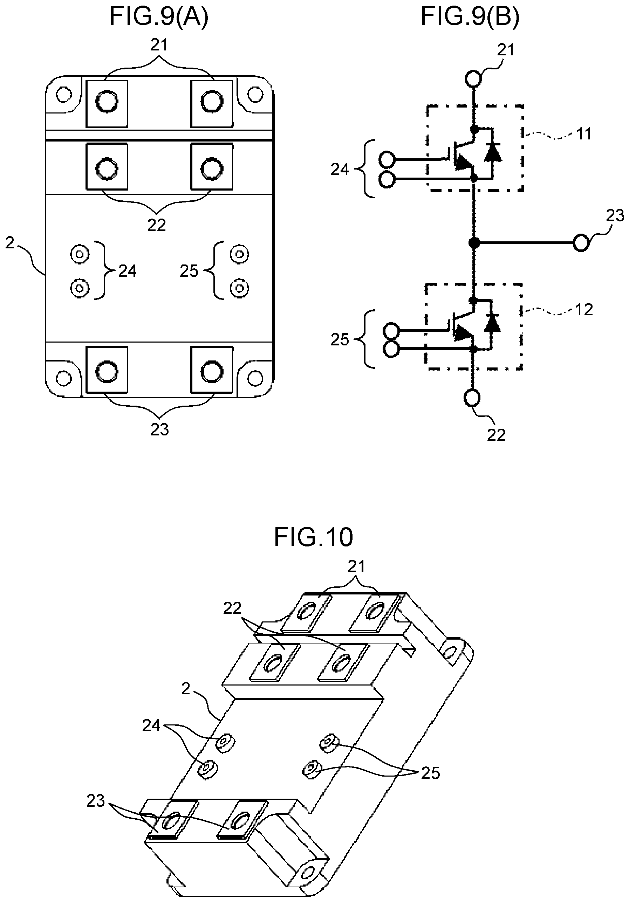

Fig. 9(A) and Fig. 9(B) are a plan view and a circuit diagram for showing a configuration example of the power semiconductor module 2, respectively. Fig. 10 is a perspective view of the power semiconductor module 2 shown in Fig. 9(A).

First, a configuration example of the power semiconductor module 2 will be described using Fig. 9(A), Fig. 9(B), and Fig. 10. In the power semiconductor module 2, a configuration of a so-called 2iN1 package is used. Here, the 2iN1 means that an element group 11 of a P-pole upper arm and an element group 12 of an N-pole lower arm shown in Fig. 9(B) are stored in one package. As one of characteristics of the power semiconductor module 2 of the package of such a 2iN1 configuration, P-pole terminals 21 and N-pole terminals 22 can be closely arranged as shown in Fig. 9(A) and Fig. 10.

The P-pole terminals 21, the N-pole terminals 22, M-pole terminals 23, and signal input terminals 24 and 25 are provided in the package. The signal input terminals 24 are terminals for driving the element group 11 of the upper arm and the signal input terminals 25 are terminals for driving the element group 12 of the lower arm.

Next, a configuration of the electric-power conversion device 1 using the power semiconductor module 2 will be described. The power semiconductor module 2 is attached to the cooler 5 including the cooling block 51 and the heat radiation member 52 so that the side of the P-pole terminals 21 and the N-pole terminals 22 faces inward and the side of the M-pole terminals 23 faces outward.

First, the busbars 7, 8, 9, 13, and 14 are provided in the electric-power conversion device 1 to be electrically connected to external devices. It should be noted that the P-pole busbar 7 and the N-pole busbar 8 show end portions of the busbars 13 and 14, respectively. As the material of these busbars 7, 8, 9, 13, and 14, copper having a small volume resistivity is employed and the cross-sectional area of a conductor is configured to be large in order to suppress heating of the conductor. Especially in the case where light weight is required, aluminum is employed in some cases as the material.

Electric connection between the P-pole terminals 21 and the N-pole terminals 22 of the power semiconductor module 2 and each terminal 10 of the filter capacitor 3 is secured by closely arranging the thin plate-like busbars 13 and 14 to which films are attached for insulation. The inductance of the main circuit can be reduced by the existence of the busbars 13 and 14.

As shown in Fig. 8, the P-pole thin-plate-shaped busbar 13 and the N-pole thin-plate-shaped busbar 14 for electrically connecting the power semiconductor module 2 and the filter capacitor 3 to each other stand in the direction vertical to the attachment surface of the power semiconductor module 2, and are fixed to the P-pole terminals 21 and the N-pole terminals 22 while being close to each other in the facing direction. This configuration is employed to reduce the inductance of the P-pole thin-plate-shaped busbar 13 and the N-pole thin-plate-shaped busbar 14. As a distance between the P-pole thin-plate-shaped busbar 13 and the N-pole thin-plate-shaped busbar 14 becomes shorter, the inductance can be reduced. However, such a configuration causes low withstand voltage, resulting in a restriction.

The filter capacitor 3 is provided near the power semiconductor module 2 along the longitudinal direction of the power semiconductor module 2 and an element attachment surface 51A of the cooling block 51 of the cooler 5, and plural terminals 10 are arranged on the side of the P-pole terminals 21 and the N-pole terminals 22. Namely, the plural terminals 10 of the filter capacitor 3 are provided on the side of the power semiconductor module 2 in the horizontal direction in the direction of the line drawings shown in Fig. 6 and Fig. 7, and connects the P-pole thin-plate-shaped busbar 13 and the N-pole thin-plate-shaped busbar 14 to each other.

In general, there is a possibility that electronic components mounted in the gate drive device 4 shown in Fig. 6 malfunction due to heat or the lifetime of the gate drive device 4 becomes short. Here, the power semiconductor module 2, wirings, the busbars, and the like generate heat by themselves, and the temperature of the vicinity thereof possibly increases. Thus, the gate drive device 4 is required to be arranged while avoiding a thermal influence by the surrounding heating components, and thus is arranged just below the filter capacitor 3 in the direction of the line drawings shown in Fig. 6 and Fig. 7.

In such a configuration, the filter capacitor 3 does not overlap with the gate drive device 4 on the terminal surface side (just below the power semiconductor module 2 in the direction of the line drawings shown in Fig. 6 and Fig. 7) of the power semiconductor module 2, and thus the height of the power semiconductor module 2, a spatial insulation distance to the gate drive device 4, and the like can be ignored. Thus, the height dimension A of the electric-power conversion device 1 according to the embodiment is minimized in the vertical direction as shown in Fig. 6, and mounting of the electric-power conversion device 1 into the low floor vehicle becomes easier.

Further, in the embodiment, a distance B between the P-pole terminals 21 and the N-pole terminals 22 of the power semiconductor module 2 and the terminals 10 of the filter capacitor 3 can be minimized, and thus the inductance of the main circuit can be reduced.

Here, when inductance is L and time is t, a bouncing voltage V that can be generated when a current i flowing in each power switching element in the power semiconductor module 2 is cut off can be represented by the following equation.

$$V=L \times di/dt$$

When the bouncing voltage V exceeds the rated voltage of the power switching element, the power switching element is damaged or the lifetime becomes short, and thus there is a restriction that a current flowing in the power switching element becomes small. As a concrete measure against this problem, plural power semiconductor modules 2 may be used while being arranged in parallel.

According to the embodiment as described above, the inductance L can be suppressed to a minimum, and thus the restriction as described above can be minimized.

(2) Second Embodiment

An electric-power conversion device 1A according to a second embodiment has substantially the same configuration and executes substantially the same operation as the electric-power conversion device 1 according to the first embodiment, and thus the explanation of the same configuration and operation will be omitted, and different points will be mainly described below.

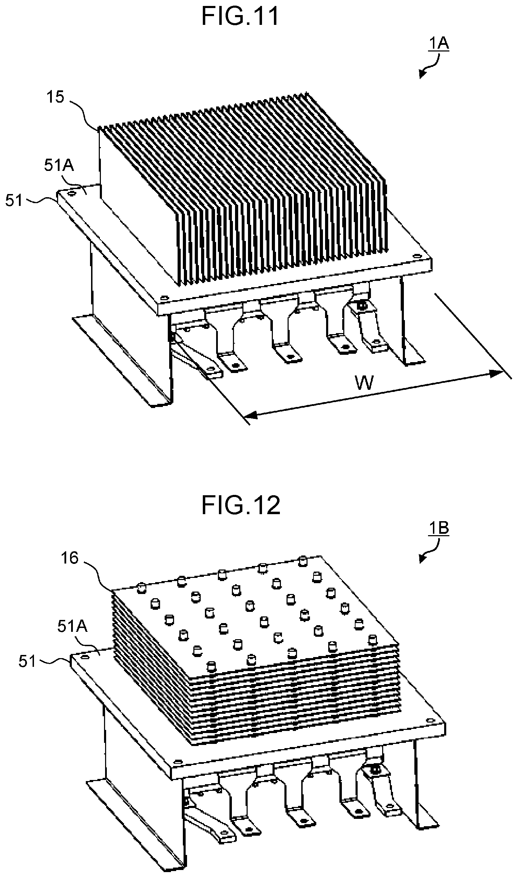

Fig. 11 is a perspective view for showing a configuration example of the electric-power conversion device 1A according to the second embodiment. In the embodiment, a fin type is employed for the heat radiation member 52 of the cooler 5. In the embodiment, the attachment direction of the power semiconductor module 2 matches that of a planar heat radiation fin 15. Namely, the heat radiation fin 15 is attached along the arrangement direction of the P-pole terminals 21 and the N-pole terminals 22 in the power semiconductor module 2.

In such a configuration, in addition to the effect obtained by the first embodiment, the configurations of the P-pole thin-plate-shaped busbar 13 and the N-pole thin-plate-shaped busbar 14 can be simplified, and the width dimension W of the cooling block 51 can be suppressed to be small. Thus, the cross-sectional area of the passage of the ventilation chamber 102 (see Fig. 1) can be reduced. Accordingly, the size of the electric-power conversion device 1A can be made smaller.

(3) Third Embodiment

An electric-power conversion device 1B according to a third embodiment has substantially the same configuration and executes substantially the same operation as the electric-power conversion device 1 according to the first embodiment, and thus the explanation of the same configuration and operation will be omitted, and different points will be mainly described below.

Fig. 12 is a perspective view for showing a configuration example of the electric-power conversion device 1B according to the third embodiment. In the embodiment, a heat pipe type is employed for the heat radiation member 52 of the cooler 5.

In such a configuration, the same effect as the first embodiment can be obtained.

(4) Fourth Embodiment

An electric-power conversion device 1C according to a fourth embodiment has substantially the same configuration and executes substantially the same operation as the electric-power conversion device 1 according to the first embodiment, and thus the explanation of the same configuration and operation will be omitted, and different points will be mainly described below.

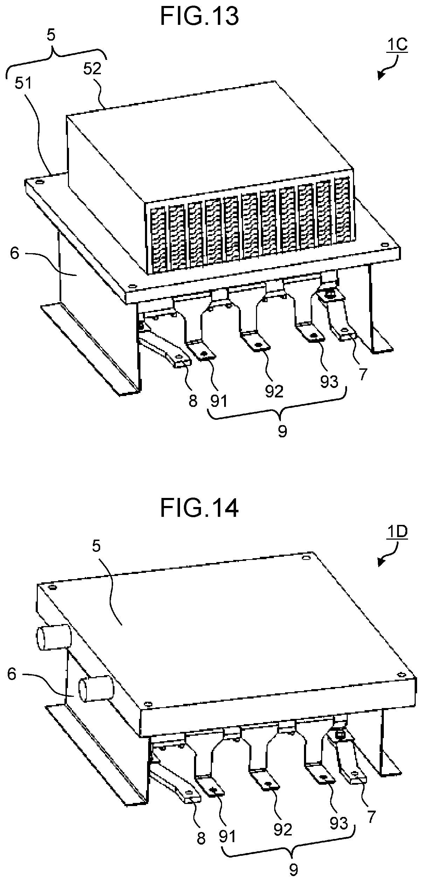

Fig. 13 is a perspective view for showing a configuration example of the electric-power conversion device 1C according to the fourth embodiment. In the embodiment, a radiator type is employed for the heat radiation member 52 of the cooler 5.

In such a configuration, substantially the same effect as the first embodiment can be obtained.

(5) Fifth Embodiment

An electric-power conversion device 1D according to a fifth embodiment has substantially the same configuration and executes substantially the same operation as the electric-power conversion device 1 according to the first embodiment, and thus the explanation of the same configuration and operation will be omitted, and different points will be mainly described below.

Fig. 14 is a perspective view for showing a configuration example of the electric-power conversion device 1D according to the fifth embodiment. In the embodiment, a water cooling-type cooler 5 is employed instead of the cooler 5 in the above-described embodiments.

In such a configuration, in addition to the effect obtained by the first embodiment, the water cooling-type does not need to include the heat radiation member 52 exposed to the cooling air 103 in the cooler 5. Thus, the electric-power conversion device 1D can be further made thinner as compared to the electric-power conversion device 1 according to the first embodiment.

(6) Sixth Embodiment

An electric-power conversion device 1E according to a sixth embodiment has substantially the same configuration and executes substantially the same operation as the electric-power conversion device 1 according to the first embodiment, and thus the explanation of the same configuration and operation will be omitted, and different points will be mainly described below.

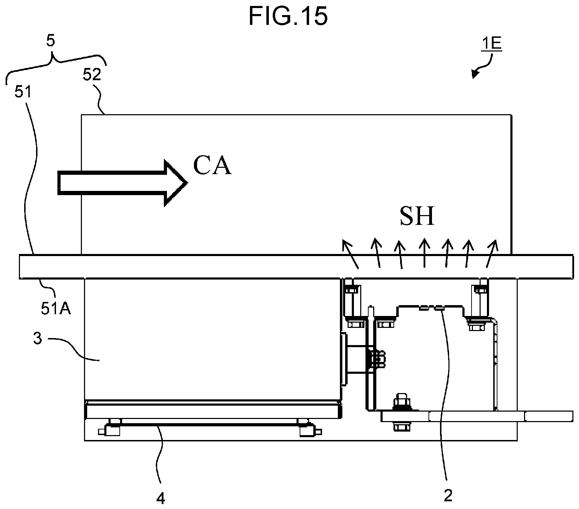

Fig. 15 is a plan view for showing a configuration example of the electric-power conversion device 1E according to the sixth embodiment. In the example shown in the drawing, the filter capacitor 3 is arranged on the windward side of the power semiconductor module 2.

In such a configuration, since the allowable temperature of the filter capacitor 3 is lower than that of the power semiconductor module 2, the filter capacitor 3 can be used even at a higher temperature of surrounding environments by arranging the filter capacitor 3 on the windward side of cooling air CA of the power semiconductor module 2 that generates heat as shown by a sign SH.

(7) Seventh Embodiment

An electric-power conversion device 1F according to a seventh embodiment has substantially the same configuration and executes substantially the same operation as the electric-power conversion device 1 according to the first embodiment, and thus the explanation of the same configuration and operation will be omitted, and different points will be mainly described below.

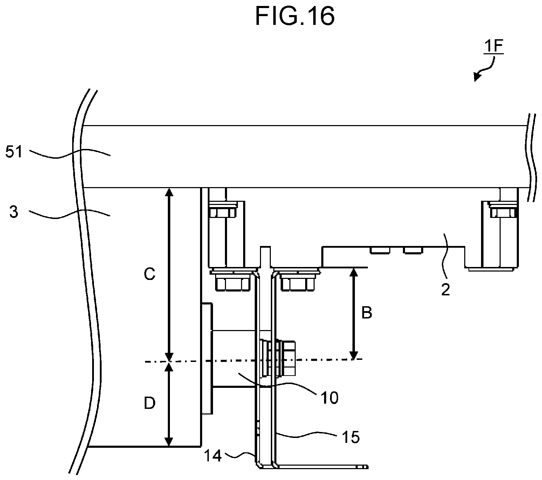

Fig. 16 is a plan view for showing a partial configuration example of the electric-power conversion device 1F according to the seventh embodiment. In the embodiment, the terminal 10 of the filter capacitor 3 is arranged at a position eccentric relative to the center of the filter capacitor 3 in the vertical direction of the element attachment surface 51A. Namely, a dimension C from the element attachment surface 51A of the cooling block 51 in the filter capacitor 3 in the vertical direction to the center of the terminal 10 is not equal to a dimension D from a surface opposite to the surface in contact with the element attachment surface 51A to the center.

In such a configuration, the inductance L of the main circuit can be reduced by minimizing a distance B between the P-pole terminals 21 or the N-pole terminals 22 of the power semiconductor module 2 and the terminal 10 of the filter capacitor 3 while securing a spatial insulation distance and a creepage distance.

(8) Eighth Embodiment

An electric-power conversion device 1G according to an eighth embodiment has substantially the same configuration and executes substantially the same operation as the electric-power conversion device 1 according to the first embodiment, and thus the explanation of the same configuration and operation will be omitted, and different points will be mainly described below.

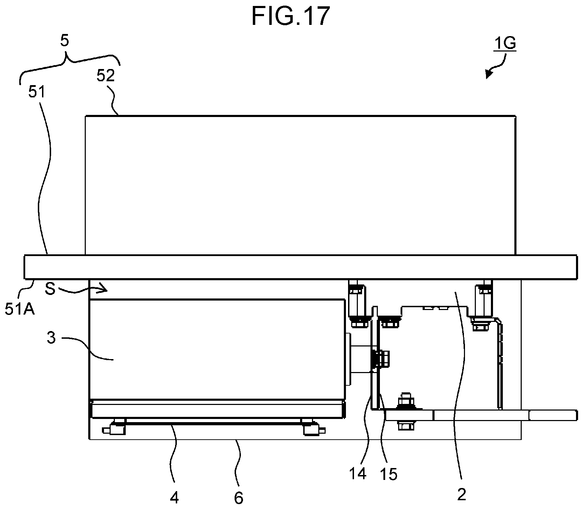

Fig. 17 is a plan view for showing a configuration example of the electric-power conversion device 1G according to the eighth embodiment. In the embodiment, a gap S is provided between a surface of the cooling block 51 facing the filter capacitor 3 and a surface of the filter capacitor 3 facing the cooling block 51. It should be noted that the gap S is provided on an entire surface or a partial surface where the filter capacitor 3 and the cooling block 51 face each other.

As described above, the filter capacitor 3 is hardly affected by heat from the power semiconductor module 2 by providing the air layer between the filter capacitor 3 and the cooling block 51 for heat insulation. In addition, since the allowable temperature of the filter capacitor 3 is lower than that of the power semiconductor module 2, even in the case where the electric-power conversion device is used in a state where the temperature of the cooling block 51 exceeds that of the filter capacitor 3, the cooling efficiency is improved because the cooling air passes through the gap S. In addition, the cooling air may pass through the gap S by providing a fan at the support frame 6 or in the housing 101 to circulate the cooling air in the housing 101.

(9) Ninth Embodiment

An electric-power conversion device 1H according to a ninth embodiment has substantially the same configuration and executes substantially the same operation as the electric-power conversion device 1G according to the eighth embodiment, and thus the explanation of the same configuration and operation will be omitted, and different points will be mainly described below.

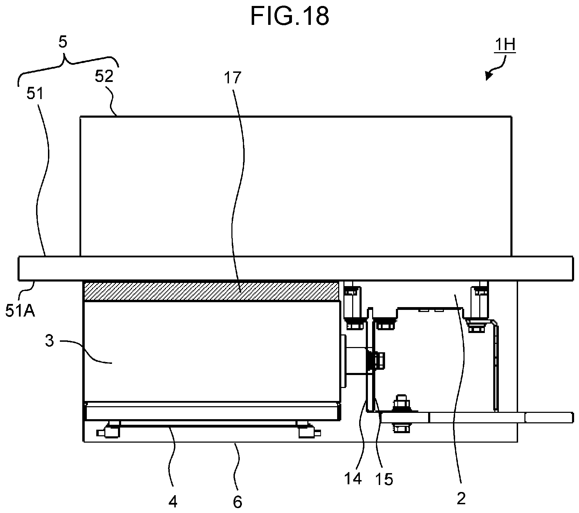

Fig. 18 is a plan view for showing a configuration example of the electric-power conversion device 1H according to the ninth embodiment. In the embodiment, as similar to the eighth embodiment, the gap S is provided between a surface of the cooling block 51 facing the filter capacitor 3 and a surface of the filter capacitor 3 facing the cooling block 51, and further the gap S is filled with a heat insulating member 17. It should be noted that the heat insulating member 17 filled in the gap S is provided on an entire surface or a partial surface where the filter capacitor 3 and the cooling block 51 face each other.

In such a configuration, even in the case where the electric-power conversion device is used in a state where the temperature of the cooling block 51 exceeds the allowable temperature of the filter capacitor 3, the cooling efficiency is further improved depending on the material of the heat insulating member 17 as compared to the eighth embodiment.

(10) Tenth Embodiment

An electric-power conversion device 1I according to a tenth embodiment has substantially the same configuration and executes substantially the same operation as the electric-power conversion device 1 according to the first embodiment, and thus the explanation of the same configuration and operation will be omitted, and different points will be mainly described below.

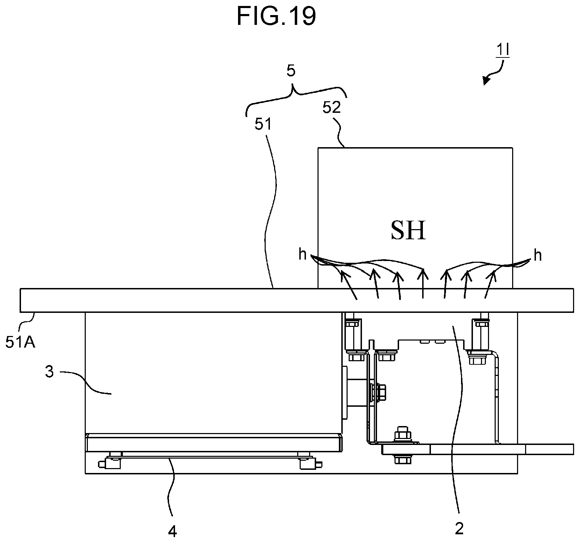

Fig. 19 is a plan view for showing a configuration example of the electric-power conversion device 1I according to the tenth embodiment. In the embodiment, the heat radiation member 52 of the cooler 5 for cooling heat SH generated by the power semiconductor module 2 is provided substantially right above the element attachment surface that is a contact surface between the power semiconductor module 2 and the cooling block 51.

By minimizing the installation area of the heat radiation member 52 as described above, the weight of the electric-power conversion device 1I can be reduced. In addition, the weight balance of the whole electric-power conversion device 1 can be improved by shifting the position of the center of gravity to the center of the electric-power conversion device 1I as near as possible.

In addition, the power of the above-described air blower 105 (see Fig. 1) can be suppressed to a minimum by minimizing the length in the ventilation direction with respect to the cooling air. Thus, the light weight of the air blower 105 and energy saving by power saving can be realized, and the running cost can be reduced.

(11) Other embodiments

The above-described embodiments are examples to explain the present invention, and the present invention is not limited to only the embodiments. The present invention can be carried out in various modes without departing from the scope thereof.

Industrial Applicability

The present invention can be widely applied to an electric-power conversion device in which a power semiconductor module is mounted.

List of Reference Signs

| | |
|---|---|
| 1 | electric-power conversion device |
| 2 | power semiconductor module |
| 3 | filter capacitor |
| 4 | gate drive device |
| 5 | cooler |
| 51 | cooling block |

| | |
|---|---|
| 51A | element attachment surface (predetermined surface) |
| 51B | surface |
| 52 | heat radiation member |
| 6 | support frame (frame) |
| 7 | P-pole busbar |
| 8 | N-pole busbar |
| 9 | M-pole busbar |
| 10 | terminal |
| 13 | P-pole thin-plate-shaped busbar |
| 14 | N-pole thin-plate-shaped busbar |
| 15 | heat radiation fin |
| 16 | heat pipe-type cooler |
| 17 | heat insulating member |
| 91 | U-phase busbar |
| 92 | V-phase busbar |
| 93 | W-phase busbar |
| 100 | control logic unit |
| 101 | housing |
| 102 | ventilation chamber |
| 103 | cooling air |
| 104 | vehicle body |
| 105 | air blower |

**Claims**

1. An electric-power conversion device comprising:

   a power semiconductor module in which each of an upper arm power switching element and a lower arm power switching element is driven in accordance with conduction modes to a P-pole terminal and an N-pole terminal;
   a gate drive device that controls conduction to the power semiconductor module through the P-pole terminal and the N-pole terminal;
   a filter capacitor in which plural terminals each of which is connected to the P-pole terminal and the N-pole terminal are formed on the power semiconductor module side;
   a cooler that cools the power semiconductor module through a predetermined surface with which the power semiconductor module comes into contact; and
   plural thin plate-shaped busbars that electrically connect the P-pole terminal and the N-pole terminal to the plural terminals,
   wherein the filter capacitor is arranged near the power semiconductor module along the predetermined surface and the plural terminals are arranged on the side of the P-pole terminal and the N-pole terminal, and
   wherein the plural thin plate-shaped busbars are formed substantially in parallel with the vertical direction with respect to the predetermined surface.

2. The electric-power conversion device according to claim 1,
   wherein the cooler includes a cooling block having the predetermined surface formed to cool the power semiconductor module through the predetermined surface, and a heat radiation member that radiates heat of the cooling block, and
   wherein the filter capacitor comes into contact with the cooling block of the cooler through the predetermined surface.

3. The electric-power conversion device according to claim 1,
   wherein a gap is formed between the filter capacitor and the cooling block of the cooler.

4. The electric-power conversion device according to claim 1,
   wherein the filter capacitor is formed on the windward side of cooling air relative to the power semiconductor module.

5. The electric-power conversion device according to claim 1,
   wherein the terminal of the filter capacitor is arranged at a position eccentric relative to the center of the filter capacitor in the vertical direction of the predetermined surface.

6. The electric-power conversion device according to claim 1,
   wherein the upper arm power switching element and the lower arm power switching element are arranged along the flowing direction of cooling air in the power semiconductor module.

7. The electric-power conversion device according to claim 1,
   wherein the cooler includes a cooling block having the predetermined surface formed to cool the power semiconductor module through the predetermined surface, and a plate-like heat radiation fin that radiates heat absorbed by the cooling block, and
   wherein the heat radiation fin is attached along the arrangement direction of the P-pole terminal and the N-pole terminal in the power semiconductor module.

8. The electric-power conversion device according to claim 1,
   wherein the gate drive device is arranged on the surface side opposite to the cooler with the filter capacitor therebetween.

9. The electric-power conversion device according to claim 1,
   wherein each of the plural busbars is formed in an L-shape and the plural busbars are arranged to face each other.

**10.** The electric-power conversion device according to claim 1,
wherein the heat radiation member of the cooler is arranged at a position substantially facing the power semiconductor module with the cooling block there-between.

# FIG.1

104

105          102

103

101

109          109

110          110

1,1A,1B,1C,1D,1E,1F,1G,1H,1I

## FIG.2

## FIG.3

FIG.4

# FIG.5

# FIG.6

# FIG.7

# FIG.8

## FIG.9(A)

## FIG.9(B)

## FIG.10

# FIG.11

# FIG.12

FIG.13

FIG.14

FIG.15

## FIG.16

# FIG.17

FIG.18

## FIG.19

## INTERNATIONAL SEARCH REPORT

International application No.

PCT/JP2018/012829

### A. CLASSIFICATION OF SUBJECT MATTER
Int.Cl. H02M7/48(2007.01)i

According to International Patent Classification (IPC) or to both national classification and IPC

### B. FIELDS SEARCHED

Minimum documentation searched (classification system followed by classification symbols)
Int.Cl. H02M7/48

Documentation searched other than minimum documentation to the extent that such documents are included in the fields searched

| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | JP 2014-96910 A (HONDA MOTOR CO., LTD.) 22 May 2014, paragraphs [0013]-[0041], fig. 1-8 (Family: none) | 1, 2, 5, 7, 10<br>3, 4, 6, 8, 9 |
| A | JP 2015-84609 A (MITSUBISHI ELECTRIC CORPORATION) 30 April 2015, entire text, all drawings (Family: none) | 1-10 |
| A | JP 2016-67078 A (DENSO CORPORATION) 28 April 2016, entire text, all drawings (Family: none) | 1-10 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 08.06.2018 | 19.06.2018 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

<table>
<tr><td colspan="2">International application No.</td></tr>
<tr><td colspan="2">PCT/JP2018/012829</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| A | US 2014/0321090 A1 (VALEO EQUIPEMENTS ELECTRIQUES MOTEUR) 30 October 2014, entire text, all drawings & WO 2013/102720 A1 & FR 2985597 A1 & CN 104335689 A | 1-10 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI111999251499 B